**Europäisches Patentamt**

**European Patent Office**

**Office européen des brevets**

(19)

(11) Numéro de publication : **0 472 451 A1**

# (12) DEMANDE DE BREVET EUROPEEN

(21) Numéro de dépôt : **91402197.7**

(22) Date de dépôt : **06.08.91**

(51) Int. Cl.⁵ : **H01L 21/68, H01L 25/065, H01L 23/538**

(30) Priorité : **21.08.90 FR 9010514**

(43) Date de publication de la demande :
**26.02.92 Bulletin 92/09**

(84) Etats contractants désignés :
**DE GB IT**

(71) Demandeur : **THOMSON-CSF**
**51, Esplanade du Général de Gaulle**
**F-92800 Puteaux (FR)**

(72) Inventeur : **Bureau, Jean-Marc**
**THOMSON-CSF SCPI Cédex 67**
**F-92045 Paris la Défense (FR)**
Inventeur : **Bernard, François**
**THOMSON-CSF SCPI Cédex 67**
**F-92045 Paris la Défense (FR)**
Inventeur : **Broussoux, Dominique**
**THOMSON-CSF SCPI Cédex 67**
**F-92045 Paris la Défense (FR)**
Inventeur : **Vergnolle, Claude**
**THOMSON-CSF SCPI Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Structure hybride d'interconnexion de circuits intégrés, et procédé de fabrication.**

(57)    L'invention concerne une méthode de réalisation d'un système d'interconnexion multicouche polymère-métal de circuits intégrés, permettant des connexions électriques et/ou optiques en deux dimensions, caractérisé en ce que l'on réalise une première couche de polymère (17), déposée sur un substrat rigide (1) de telle façon que cette couche soit séparable du substrat, et en ce que l'on réalise ensuite sur cette première couche un système multicouche d'interconnexion (99) selon les méthodes de l'homme de l'art, et en ce que le substrat rigide est retiré après assemblage et connexion des circuits intégrés (2). En superposant de telles structures on peut facilement réaliser des structures tridimensionelles.

EP 0 472 451 A1

FIG.4

L'invention concerne un système d'assemblage et d'interconnexion de circuits et son procédé de réalisation. L'invention concerne un système d'interconnexion électrique de circuits en deux dimensions (2D), d'une part, et d'autre part l'invention concerne également l'interconnexion électrique de systèmes 2D ainsi obtenus dans une structure à trois dimensions (3D).

L'invention concerne aussi un système d'assemblage et d'interconnexion électrique et/ou optique, en 2D et en 3D, de circuits intégrés.

L'invention concerne enfin également un procédé de réalisation de tels systèmes d'interconnexion des circuits intégrés.

Le système selon l'invention est composé d'un multicouche polymère-métal autosupporté sur lequel les circuits sont connectés.

Dans l'art antérieur, il est connu d'assembler des circuits intégrés (des "puces") sur des circuits d'interconnexion réalisés (en 2D) sur un substrat rigide (module hybride ou circuit imprimé, aussi connu sous le nom "carte"). Il est aussi connu d'assembler plusieurs de ces modules ou cartes dans une structure 3D, soit par des connecteurs électriques se trouvant en périphérie des modules ou cartes, qui sont connectés dans une structure rigide conçue pour recevoir ces modules ou cartes et pour assurer des connections électriques entre elles et avec l'extérieur ; soit par empilage des modules ou cartes avec des interconnexions électriques entre des modules ou cartes voisines.

Avec la croissance soutenue du nombre d'éléments électroniques assemblés dans les équipements modernes, et avec la miniaturisation de ceux-ci, la densité d'interconnexions requises entre des éléments dans les circuits complexes devient un facteur limitant pour l'avancement de l'état de l'art.

En même temps, la complexité croissante des circuits, l'augmentation du nombre des entrées de sorties (1/0) de signaux électroniques et du débit des signaux dans et entre ces circuits, ainsi que les faibles grandeurs physiques (courant, tension) caractérisant ces signaux, introduisent des problèmes croissants liés à la fiabilité des interconnexions.

La tendance actuelle des systèmes d'interconnexion pour l'intégration de l'électronique à haute densité (VLSI, ou "Very Large Scale Intégration" en anglais) est d'aller vers un système hybride, selon lequel les puces nues sont interconnectées directement sur un substrat commun, qui assure à la fois le support mécanique les circuits, les moyens d'interconnexion, la communication avec l'extérieur, et souvent l'évacuation de chaleur générée par des composants dissipatifs.

Le substrat, avec ses nombreuses puces nues rapportées et plusieurs couches diélectriques séparant plusieurs couches d'interconnexions métalliques, est ensuite enfermé dans un boîtier hermétique (multichip packaging, en anglais).

Les critères utilisés dans la conception d'un système d'interconnexion, dont l'importance relative relève de l'application précise auquel le matériel est destiné, sont donc des paramètres tels que : la densité, le rendement, la performance, la fiabilité, la dissipation thermique. Souvent le choix d'un système d'interconnexion implique un compromis parmi ces paramètres.

Parmi les diélectriques utilisables pour l'isolation des différences couches conductrices, les polyimides ou d'autres polymères thermostables comme les polyphénylquinoxalines, par exemple, sont appréciés pour leurs possibilités de mise en oeuvre (dépôt, ouverture de vias pour connexions entre couches conductrices, planarisation, etc ...), ainsi que leur faible permittivité diélectrique (par rapport aux diélectriques minéraux), ce qui autorise leur utilisation des plus hautes fréquences.

L'utilisation d'interconnexion multicouches polyimide-métal (Al ou Cu) sur différents types de substrats est bien connue de l'art antérieur.

Par exemple, il est connu d'utiliser le silicium comme substrat, associé à des techniques de lithographie monolithique pour réaliser un système d'interconnexion multicouche de haute densité. Les équipements et le savoir-faire des procédés courants de la microlectronique sur silicium peuvent être appliqués directement, et, de ce fait, un très haut niveau de résolution (et donc de densité) du système d'interconnexion peut être obtenu, avec un bon rendement de fabrication.

Sur le système d'interconnexion ainsi réalisé, les circuits intégrés ("puces") sont assemblés et connectés par les techniques connues de l'homme de l'art dont les plus répandues sont : le Transfert Automatique sur Bande (TAB), la puce à l'envers (flip-chip pour les anglophones), ou la fixation de fils (wire-bonding en anglais).

Dans tous ces systèmes d'interconnexion connus de l'art antérieur, des dites de l'état de l'art en termes de densité, de performances, et de fiabilité proviennent en bonne partie de la connexion électrique des puces.

Ainsi, il a été proposé pour connecter ces puces d'utiliser les techniques dérivées de procédés connus de circuits intégrés (lithographie, dépôt de couches minces, ...) sur substrat monolithique afin d'obtenir la haute densité, les hautes performances, la fiabilité et le haut rendement de fabrication de ces techniques déjà bien maîtrisée de la microélectronique sur silicium.

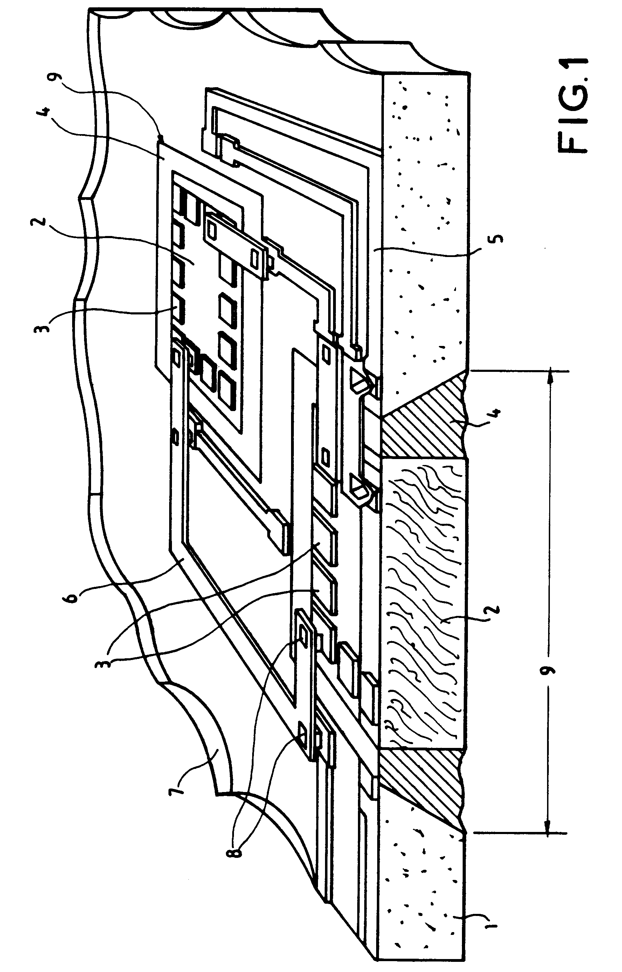

Ces procédés étant essentiellement planaires, il est alors nécessaire de mettre au même niveau la surface des circuits intégrés et celle du substrat. Dans l'art antérieur, ceci peut être obtenu par la découpe d'alvéoles dans le substrat silicium, le positionnement et fixation des puces dans ces alvéoles, et la "planarisation", ce qui consiste à tout recouvrir d'une résine organique qui rend la surface plane (figure 1).

Trois problèmes rencontrés avec cette technique sont la difficulté d'obtenir le centrage correct de la puce par rapport aux plots d'interconnexion du substrat, une très grande difficulté pour effectuer des réparations des puces défaillantes, et les contraintes mécaniques dues aux coefficients de dilatation thermiques des différents matériaux.

Une autre technique proposée consiste à coller un film de Kapton Tm sur les puces préalablement positionnées sur un substrat, et la définition des interconnexions par écriture directe à l'aide d'un laser piloté par microprocesseur. Cette méthode, en plus des mêmes problèmes de réparation que la précédente (nécessité de refabriquer le système d'interconnexion en cas de remplacement d'une puce défaillante), ne permet qu'une densité d'interconnexions relativement faible.

Ces structures d'interconnexion en deux dimensions (2D) sur substrat, en plus des inconvénients déjà mentionnés ci-dessus ont en commun une difficulté de réalisation des connexions électriques à travers le substrat, nécessaires dans le cas d'une structure 3D.

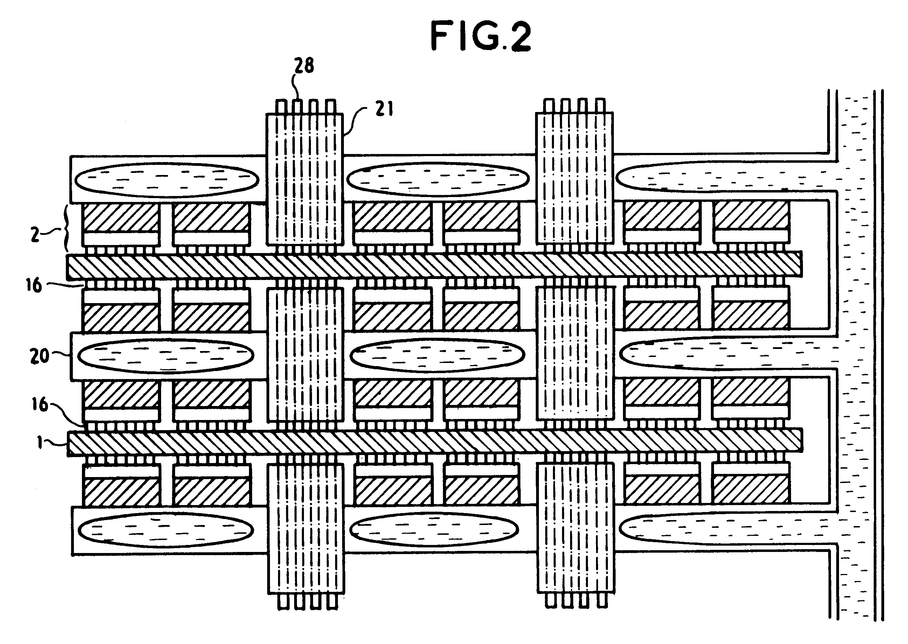

Il a également été proposé de réaliser une structure d'interconnexion en trois dimensions (3D) par empilage de structures (2D) (figure 2). Dans un système (3D) d'interconnexion utilisant ces méthodes, l'épaisseur du substrat, de l'ordre de 500 microns, occupe une partie importante du volume total de l'ensemble. De plus, la réalisation de connexions électrique à travers ce substrat est technologiquement très difficile.

L'invention a précisément pur but de pallier ces inconvénients de l'art antérieur, aussi bien pour les systèmes d'interconnexions en deux dimensions que pour les systèmes d'interconnexion en trois dimensions

L'invention permet de s'affranchir de tous les inconvénients liés à l'utilisation d'un substrat dans un système d'interconnexion, à savoir : les étapes nécessaires à la mise en oeuvre du substrat, tels l'usinage des alvéoles, le positionnement des puces, la planarisation par dessus, etc.. . Dans un système d'interconnexion en trois dimensions, l'invention permet de s'affranchir de l'espace occupé par le substrat, et donc d'accroître la densité de composants actifs et d'interconnexions réalisable dans un volume donné, et permet de s'affranchir des problèmes de réalisation de connexions à travers ce substrat.

L'invention propose d'utiliser un substrat rigide seulement dans certaines étapes de fabrication, et de le retirer ensuite.

Le système proposé par l'invention peut être facilement adapté pour l'interconnexion optique des circuits munis d'émetteurs et de détecteurs optoélectroniques en 3D comme en 2D.

L'invention a donc pour objet une méthode de réalisation d'une structure hybride utilisant un système d'interconnexion multicouche polymère-métal de circuits intégrés, permettant des connexions électroniques et/ou optiques en deux dimensions, caractérisé en ce que l'on réalise sur un substrat rigide un système d'interconnexions multicouche séparable du substrat, en ce que l'on met en place les circuits intégrés sur le système multicouches, et en ce que le substrat rigide est retiré après mise en place et connexion des circuits intégrés.

L'ensemble du système d'interconnexions portant lespuces connectées entre elles est alors autosupporté.

L'invention concerne aussi une méthode de réalisation de structures hybrides à interconnexion optique et/ou électrique en trois dimensions, caractérisé en ce que des systèmes multicouches autosupportés d'interconnexion en deux dimensions sont réalisés selon le paragraphe précédent, et en ce que, après que ledit substrat rigide ait été retiré, des plots de connexion sont réalisés sur la face du système multicouche d'interconnexion qui a été libérée par le retrait du substrat, et caractérisé en ce que les systèmes multicouches d'interconnexion en deux dimensions sont ensuite empilés et interconnectés entre eux à l'aide de ces plots de connexion.

L'invention concerne également une structure hybride utilisant un système d'interconnexion multicouche polymère-métal de circuits intégrés, permettant des connexions électriques et/ou optiques entre circuits intégrés disposés en deux dimensions sur un plan, réalisé selon les méthodes des paragraphes précédents.

L'invention a aussi pour but un système d'interconnexion de circuits intégrés en trois dimensions, caractérisé en ce que plusieurs systèmes multicouches autosupportés à deux dimensions réalisés selon le paragraphe précédent sont empilés et connectés entre eux, ces connexions étant réalisables notamment sur la face du système multicouche libérée par l'enlèvement du substrat.

L'invention sera mieux comprise et d'autres avantages apparaîtront à la lecture de la description qui va suivre, donnée à titre non limitatlf, et grâce aux dessins annexés parmi lesquels :

– la figure 1, déjà mentionnée, montre en perspective un exemple de réalisation d'un système d'interconnexion électrique sur substrat selon l'art antérieur ;

– la figure 2, déjà mentionnée, montre un exemple de réalisation d'un système d'interconnexion électrique en trois dimensions par empilage des systèmes d'interconnexion sur substrat selon l'art antérieur ;

– les figures 3 à 6 montrent schématiquement les principales étapes d'une méthode de réalisation d'un système d'interconnexion multicouche polymère-métal de circuits intégrés en deux dimensions (2D) selon l'invention ;

– la figure 7 montre schématiquement un exemple de réalisation d'un système d'interconnexion et trois dimensions par empilage des systèmes d'interconnexion 2D selon l'invention ;

– la figure 8 montre schématiquement en plan et en coupe un exemple de réalisation d'un système d'interconnexion optique et électrique en deux dimensions.

Les mêmes repères désignent les mêmes éléments sur toutes les figures.

Sur la figure 1, qui illustre l'art antérieur, on voit que le substrat 1, en silicium par exemple, sur lequel repose un premier niveau d'interconnexions métalliques 5, a été percé d'alvéoles 9 pour permettre l'insertion des circuits intégrés 2 avec leurs plots de connexion, et que par la suite une résine 4 de planarisation est utilisée pour remplir l'espace autour du circuit, de façon à ce qu'une première couche d'isolation diélectrique 7, de polymère, par exemple, puisse être déposée sur le premier niveau d'interconnexions métalliques 5. Pour permettre des connexions électriques à travers cette couche diélectrique, des trous ou "vias" 8 sont réalisés dans la couche diélectrique aux endroits souhaités, et un deuxième niveau 6 de métallisation peut être tracé, selon les méthodes de photolithographie ou toute autre méthode pratiquée par l'homme de l'art. D'autres couches de diélectriques et de métallisations (non montrées) peuvent être déposées de la même façon, jusqu'au niveau de complexité exigé par l'application.

Sur la figure 2, l'on voit un exemple d'un système d'interconnexion en trois dimensions (3D) proposé dans l'art antérieur, réalisé par empilage des systèmes 2D. Le substrat 1, en silicium par exemple, avec ces multicouches métal/diélectrique d'interconnexions (non montrées), porte des circuits intégrés 2 montés sur les deux faces à l'aide des bossages métalliques 16 par la méthode de puce à l'envers, connu de l'homme de l'art sous le nom anglais "flip chip".

L'évacuation de chaleur dissipée dans les puces est assurée par des conduits thermiques 20, qui peuvent être de simples "doigts thermiques" pour évacuation par conduction, ou bien peuvent permettre la circulation d'un liquide de refroidissement. Les interconnexions électriques entre les structures 2D se font par les vias 28 qui traversent les éléments de structure 21, connectés à leurs extrémités par des bossages métalliques 16, et par des vias (non montrés) réalisés à travers les substrats 1.

On remarque sur ce dessin schématique le volume important occupé par le substrat 1.

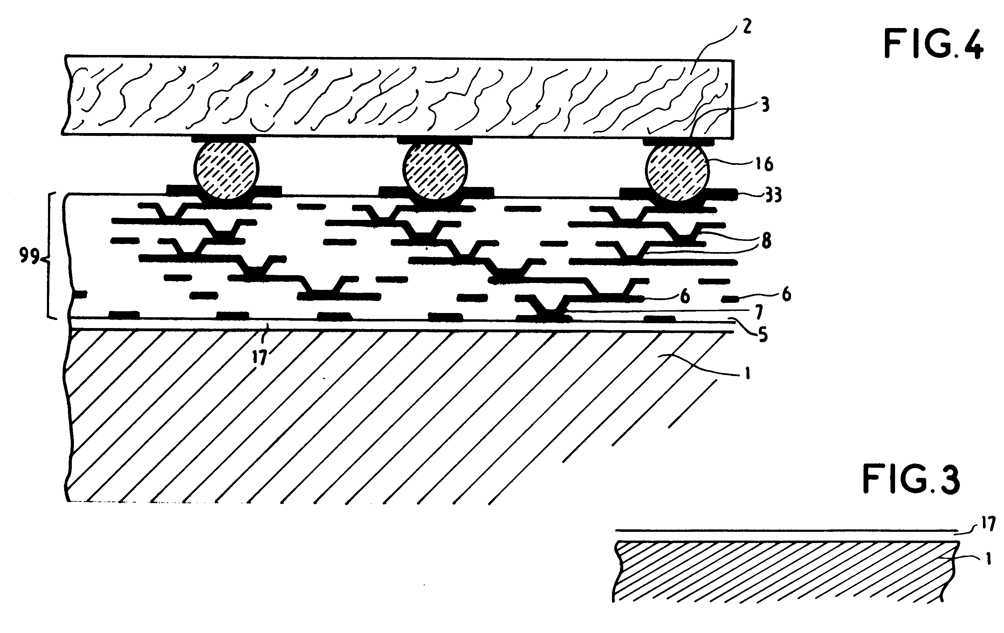

Les figures 3 à 6 montrent les étapes d'un exemple de procédé de réalisation de système d'interconnexions électriques selon l'invention.

Sur la figure 3, l'on voit schématiquement la première étape qui consiste à déposer une première couche de polymère 17, de un à quelques micromètres d'épaisseur, sur un substrat 1 qui sera avantageusement de silicium ou de silice utilisé en microélectronique, de telle façon à ce que cette couche puisse être par la suite séparée facilement du substrat.

Cela peut être par exemple une couche de polyimide 17 déposée par les techniques connues de l'homme de l'art, telles que la centrifugation ("spin coating") ou la pulvérisation ("spray") sur le substrat d'une solution d'acide polyamique ou de polyimide soluble. Ce type de dépôt peut être décollé ou pelé par trempage dans un liquide polaire tel que l'eau, par exemple, éventuellement assisté d'ultrasons. Ce peut être encore une couche déposée par collage ou par laminage d'un film de polymère 17 sur un substrat à l'aide d'un adhésif thermoplastique ou soluble. La couche ainsi collée peut être séparée du substrat par l'action de la chaleur ou d'un solvant

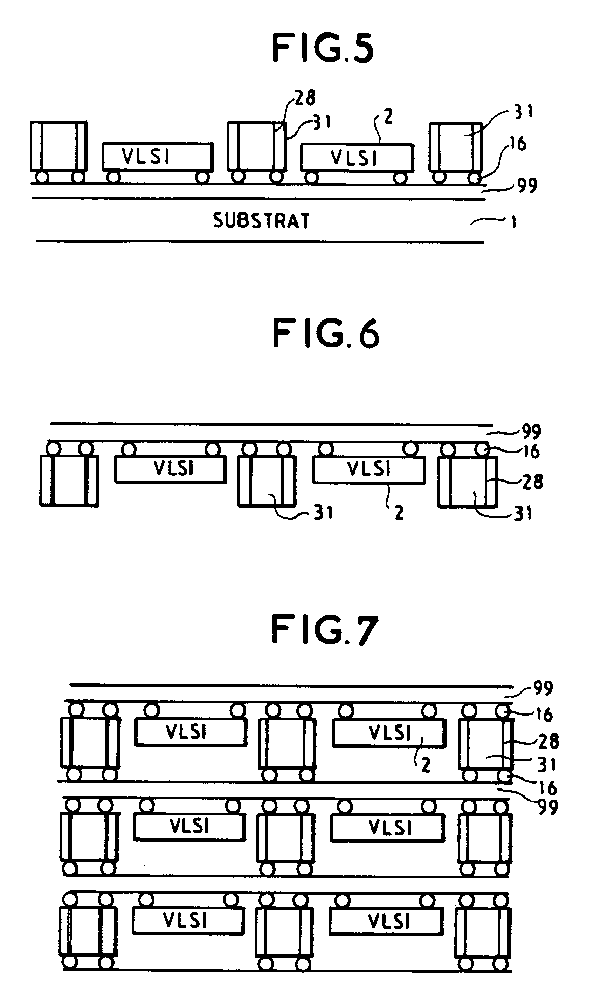

Sur la figure 4, on voit que la deuxième étape consiste à réaliser un système d'interconnexions électriques multicouches métal/polymère selon l'état de l'art, dont quelques exemples ont été donnés sur les figures précédentes. Pour éviter la séparation des couches du système multicouches, l'on peut aussi utiliser un promoteur d'adhérence ou effectuer une co-cuisson du système déposé.

Sur la figure 4, l'on distingue le substrat 1, la première couche de polymère 17, et puis plusieurs couches d'interconnexions métalliques 5, 6, etc ... séparées par des couches de polymère 7, avec des vias conducteurs 8 dans les couches de polymère, pour connecter les différents niveaux d'interconnexion comme dans les cas précédents. Sur le dernier niveau de métallisation, des plots de connexion 33 sont réalisés; ils sont destinés à être reliés à des plots correspondants sur les puces qui seront ultérieurement mises en place. Les puces sont ensuite mises en place selon la méthode d'assemblage choisie par le concepteur (soudage de fils, TAB, flip-chip).

La méthode "flip-chip" est particulièrement avantageuse si elle est employée dans le cadre de la présente invention, et sera plus spécialement décrite dans les figures 4 à 7. Des bossages métalliques 16 sont préalablement formés sur chacun des plots de connexion 3 des puces 2, et ces bossages sont ensuite connectés aux plots 33 du système d'interconnexion multicouche, par refusion. Cette technique assure le meilleur positionnement des puces 2 par autocentrage dû à la tension de surface des petites gouttes de métal liquide. Il y a aussi un avantage en ce qui concerne la densité de connexions réalisables par cette technique, car les plots 3 sur la puce ne sont pas limités à la seule périphérie de la puce, donc peuvent être sensiblement plus nombreux. Enfin, la réfusion des bossages permet d'ôter et de remplacer les circuits défaillants, donc la réparabilité de ce système est meilleure.

Une variante de cette technique flip-chip pourrait également être employée, qui consiste à utiliser des bossages composées d'une résine thermoplastique chargée électroconductrice au lieu d'un métal ou alliage métallique. L'emploi d'un tel matériau rend la réparabilité encore plus aisée et sa souplesse mécanique permet le réduire les contraintes dues aux différences de coefficients le dilatation entre les puces et le système d'interconnexion.

Le système d'interconnexion multicouche est désigné par la référence 99.

Dans la prochaine étape montrée sur la figure 5, un élément de rigidité tel qu'un cadre 31 est fixé et connecté sur le système d'interconnexion 99, avantageusement mais non exclusivement à l'aide de bossages identiques aux bossages 16 utilisés pour fixer les puces 2 sur le système 99 d'interconnexion selon la méthode flip-chip décrite ci-dessus. Ce cadre possède des alvéoles ajourées correspondant aux positions des puces 2, et il possède de préférence un système de conducteurs 28 qui le traverse d'une face à l'autre dans un sens perpendiculaire à la surface du système multicouche 99 portant les puces 2.

Ce cadre peut être constitué de tout matériau conducteur (métal) ou diélectrique (céramique, silicium isolant, verre, polymère, etc ...) et peut être moulé, usiné, ou assemblé de pièces. Le matériau et les dimensions peuvent être choisis, selon la conception propre à l'application pour permettre l'évacuation de chaleur, ou pour fournir une masse électrique, ou encore pour servir de support mécanique pour un boîtier ou pour des connexions électriques avec l'extérieur.

La cadre pourrait être, par exemple, réalisé avantageusement en polymère thermodurcissable ou thermoplastique à haute tenue en température (par exemple : polyimide de condensation ou d'addition epoxide, polyéthérimide, polyéthersulfone, polyétheréthercétone, polysulfure de phénylène, polymère cristal liquide, etc ...).

Le réseau conducteur 28 dans le cadre peut être réalisé par l'insertion de conducteurs mis en place lors du moulage, ou encore par perçage suivi d'un remplissage ou d'un dépôt conducteur, ou par toute autre méthode. Dans le cas d'un cadre conducteur, ce réseau est isolé à l'intérieur du cadre conducteur; il peut alors constituer des lignes de transmission blindées par le cadre lui-même, ce qui peut être intéressant pour transmettre des signaux à l'abri de toute interférence électromagnétique éventuelle.

La dernière étape, montrée sur la figure 6, consiste à enlever le substrat 1, laissant le cadre 31 et les puces 2 fixés sur le système d'interconnexion 99 à l'aide des bossages 16. La rigidité de l'ensemble est assurée par le cadre.

Le substrat retiré, des bossage peuvent être réalisés sur l'autre face du système d'interconnexion 99, ces vias étant connectés aux conducteurs du réseau 28 du cadre 31 ; ces bossages permettent l'empilage des systèmes 2D en un système 3D tel que montré sur la figure 7. Les connexions entre les systèmes 2D empilés sont assurés à travers les cadres rigides 31 par le réseau de conducteurs 28 déjà décrit.

Les dimensions des cadres sont choisis pour permettre l'espacement des circuits dans un système 2D et l'espacement des systèmes 2D dans un système 3D de façon à optimiser la densité de l'électronique tenant compte des besoins d'évacuation de chaleur, qui peut être réalisée comme dans le système montré sur la figure 2 par l'adjonction de doigts thermiques (barreaux conducteurs de la chaleur venant en contact avec la face libre des puces et passant à travers les cadre 31 pour rejoindre l'extérieur) ou d'un système de circulation d'un fluide caloporteur (air, Fréon (TM), Fluorinert (TM), etc ...) traversant les cadres rigides 31 et venant refroidir les puces entourées par ces cadres.

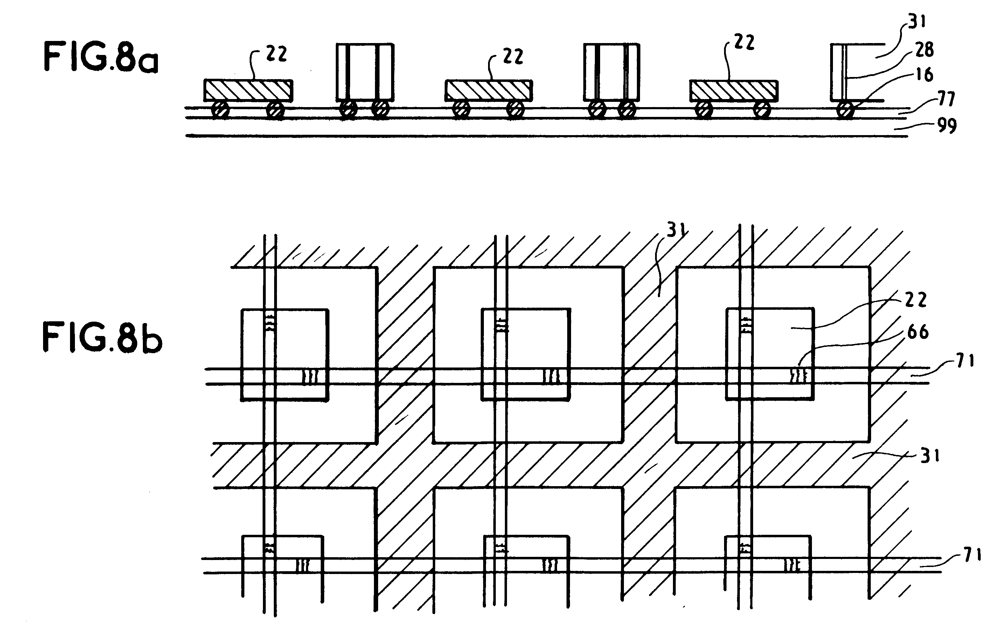

La figure 8 montre schématiquement en plan (8B) et en coupe (8A) un exemple en 2D d'une variante de l'invention comprenant des connexions optiques entre des dispositifs optoélectroniques.

Comme dans les cas précédents, la méthode flipchip est utilisée à titre d'illustration non-limitative pour les interconnexions électriques. Comme dans les cas précédents, les puces, qui sont ici des dispositifs optoélectroniques 22, sont assemblées sur un système d'interconnexion électrique métal/polyimide auto supporté 99, dont la rigidité est assurée par le cadre 31 avec ses vias 28 dans le cas où on fait un empilage pour former une structure 3D. Ces dispositifs optoélectroniques peuvent comprendre à la fois des circuits intégrés optoélectroniques et des circuits intégrés électroniques classiques (donc n'ayant pas besoin d'interconnexions optiques), ou encore de simples photodétecteurs ou émetteurs des signaux lumineux.

Par rapport aux systèmes d'interconnexion montrés sur les figures précédentes, il est ajouté une dernière couche diélectrique 77 entre le système d'interconnexion multicouche 99 et les circuits 22 et cadre 31. Cette couche de diélectrique est réalisée sur la face du système d'interconnexion multicouches 99 possédant les plots de connexion 33, sans toutefois recouvrir ces plots ; dans cette couche diélectrique 77 sont réalisées des guides optiques 71 qui serviront à acheminer les signaux lumineux entre les dispositifs à interconnecter optiquement.

Ces guides optiques peuvent être réalisées par les techniques de photolithographie, soit par insolation UV d'un polymère photosensible à travers un masque, soit par gravure ionique réactive à travers un masque d'aluminium préalablement déposé, réalisant ainsi dans la couche diélectrique des pistes d'indice de réfraction différent de celui du reste de la couche; ces pistes constituent alors des guides optiques. Elles sont rectilignes sur la figure 8, mais peuvent prendre des formes diverses et variées selon les interconnexions à effectuer.

Dans le cas de cet exemple, des réseaux de diffraction (pouvant être réalisés par photolithographie à la surface des guides) assurent le couplage optique entre les guides et les composants optoélectroniques.

**Revendications**

1. Une méthode de réalisation de système d'interconnexion multicouche polymère-métal de circuits intégrés, permettant des connexions électriques et/ou optiques en deux dimensions, caractérisé en ce que l'on réalise sur un substrat rigide (1) un système multicouche d'interconnexion (99), en ce qu'on met en place des puces (2) sur ce système, et en ce que le substrat rigide est retiré après mise en place et connexion desdits circuits intégrés, laissant le système multicouche de connexion autosupporté.

2. Une méthode de réalisation de système d'interconnexion multicouche polymère-métal de circuits intégrés selon la revendication 1, caractérisé en ce que l'on fixe sur le système multicouche d'interconnexion, avant de retirer le substrat rigide, un cadre rigide (31) entourant les puces.

3. Une méthode de réalisation de système d'interconnexion multicouche polymère-métal de circuits intégrés selon la revendication 2, caractérisé en ce que l'on fixe, avant de retirer le substrat rigide, lesdits circuits intégrés et ledit cadre rigide sur le système multicouche d'interconnexion selon la méthode de fusion de bossages (16), autrement connue sous le nom anglophone de "flip-chip".

4. Une méthode de réalisation de système d'interconnexion électrique et/ou optique en trois dimensions, caractérisé en ce que des systèmes multicouches autosupportés d'interconnexion en deux dimensions sont réalisés selon l'une des revendications 2 ou 3, en ce qu'après ledit substrat rigide est retiré, des plots de connexion sont réalisés sur une première couche dudit système multicouche, située sur la face du système multicouche d'interconnexion qui a été libérée par le retrait dudit substrat, et caractérisé en ce que les systèmes multicouches d'interconnexion en deux dimensions sont ensuite empilés et interconnectés entre eux à l'aide de ces plots de connexion et dudit cadre rigide.

5. Structure hybride comportant des circuits intégrés et un système d'interconnexion multicouche polymère-métal entre ces circuits, permettant des connexions électriques et/ou optiques entre circuits intégrés disposés en deux dimensions sur un plan, caractérisée en ce que ledit système multicouche est réalisé selon l'une des revendications 1 à 3.

6. Structure hybride selon la revendication 5, caractérisée en ce qu'elle comporte :
   – un système multicouche d'interconnexion (99) possédant, au moins sur une face principale, un ou plusieurs plots de connexion (33)
   – au moins un circuit intégré possédant un ou plusieurs plots de connexion (3) connectés électriquement aux plots ( 33 ) du système,
   – et au moins un élément de rigidité fixé mécaniquement à ladite face principale.

7. Structure hybride selon la revendication 6, caractérisée en ce que l'élément de rigidité est un cadre qui entoure le circuit intégré.

8. Structure hybride selon la revendication 7, caractérisée en ce que le cadre est traversé par des conducteurs.

9. Structure hybride selon la revendication 7, caractérisé en ce que le cadre est en matériau conducteur et les conducteurs qui le traversent sont isolés du cadre, le cadre formant un blindage pour les conducteurs.

10. Structure hybride selon l'une des revendications 5 à 9, caractérisé en ce qu'elle comporte un empilement de structures, formant un système tridimensionnel d'interconnexions de circuits intégrés.

11. Structure selon l'une des revendications 5 à 10, caractérisé en ce que le système d'interconnexion multicouche comporte des guides optiques pour transmettre des signaux optiques.

FIG.1

EP 0 472 451 A1

FIG.2

EP 0 472 451 A1

FIG.4

2

3

16

33

8

99

6       6

7

5

10

17                                                1

EP 0 472 451 A1

FIG.3

17

1

# FIG.5

# FIG.6

# FIG.7

FIG.8a

FIG.8b

EP 0 472 451 A1

Office européen
des brevets

**RAPPORT DE RECHERCHE EUROPEENNE**

Numero de la demande

EP 91 40 2197

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 091 072 (CIT-ALCATEL) * Revendication 1 * | 1 | H 01 L 21/68 |
| A | --- | 2 | H 01 L 25/065 H 01 L 23/538 |
| Y | EP-A-0 029 334 (SECR. OF STATE) * Revendication 1 * | 1 | |
| A | GB-A-2 202 673 (AHMED-HOPPER) * Revendication 1; page 7, lignes 12-27 * | 1,2 | |
| A | FR-A-2 634 322 (THOMSON) * Revendication 1; page 8, lignes 6-17 * | 1,2,5-7 | |
| A | FR-A-2 312 172 (IBM) * Revendication 1; figure 1 * | 3,4,10 | |
| A | IBM TECHNICAL DISLCOSURE BULLETIN, vol. 22, no. 5, octobre 1979, pages 1839-1840, New York, US; B.T. CLARK et al.: "Integrated stacking spacer for metallized ceramic modules" | 8 | DOMAINES TECHNIQUES RECHERCHES (Int. Cl.5) H 01 L |
| A | EP-A-0 103 889 (SIEMENS) * Revendications 1,7 * | 9 | |
| A | OPTICS COMMUNICATIONS, vol. 73, no. 1, 1 septembre 1989, pages 23-31, Amsterdam, NL; J.J. COUSTY et al.: "Study of grooves in silicon chip as means of optical interconnections in VLSI circuits" * Résumé * --- -/- | 11 | |

Le présent rapport a été établi pour toutes les revendications

| Lieu de la recherche | Date d'achèvement de la recherche | Examinateur |
|---|---|---|
| LA HAYE | 10-10-1991 | DE RAEVE R.A.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EP O FORM 1503 03.82 (P0402)

**Office européen des brevets**

# RAPPORT DE RECHERCHE EUROPEENNE

Numero de la demande

EP 91 40 2197

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | IBM TECHNICAL DISCLOSURE BULLETIN, vol. 8, no. 10, mars 1966, pages 1325-1326, New York, US; N.E. BEVERLY et al.: "Multilayer electronic package" ----- | | |
| | | | **DOMAINES TECHNIQUES RECHERCHES (Int. Cl.5)** |

Le présent rapport a été établi pour toutes les revendications

| Lieu de la recherche | Date d'achèvement de la recherche | Examinateur |
|---|---|---|
| LA HAYE | 10-10-1991 | DE RAEVE R.A.L. |

EPO FORM 1503 03.82 (P0402)